# EUROPEAN PATENT APPLICATION

(11) **EP 3 614 818 A1**
(43) Date of publication of application: **26.02.2020**
(21) Application number: 18189823.0
(22) Date of filing: 20.08.2018
(51) Int. Cl.: H05K 7/20

(54) **HOT/COLD AISLE SYSTEM**

(71) Applicant: Breffni Air Ireland Limited, Co. Cavan Co. Cavan (IE)
(72) Inventor: Sheanon, Patrick, Co. Monaghan (IE); Fitzsimons, Hugo, Co. Meath (IE); Smith, Kieran, Co. Cavan (IE)
(74) Representative: Schütte, Gearoid

(57) **Abstract**

A prefabricated hot/cold aisle system (1) has a prefabricated self-supporting rigid frame (2) having a top (3) and downwardly depending sides (4) defining an aisle (5) therebetween. A roof comprising sheeting or roofing panels, is mounted on the top (3) of the frame (2) to close the top (3) of the frame (2). A plurality of window panels are mounted along each side (4) to close the sides (4) of the frame (2). Means for mounting the frame (2) on a support such as a building structure comprises a plurality of hangers (11) at the top (3) of the frame (2) to suspend the frame (2) from overhead rafters in the building structure. Alternatively, the frame (2) could be mounted on support feet. The frame (2) is rigid enough to allow the system (1) to be prefabricated remotely in a factory and transported by road to a site for installation.

## Description

### Introduction

This invention relates to a hot/cold aisle system for a data centre.

In a data centre it is known to provide a hot or cold aisle associated with rows of server switch cabinets to deliver cooling air to the server switch cabinets and remove hot air from the server switch cabinets. Essentially, an aisle is formed between two adjacent parallel rows of server switch cabinets. A data centre may have many rows of server switch cabinets housed in a building. Usually the aisles are built in-situ. Commonly a frame is constructed extending upwardly from the server cabinets and cladded with panels to form a sealed enclosure to direct cooling air to or hot air away from the server switch cabinets. As such frames are constructed from a number of frame elements which have to be bolted together to construct the frame, and given the large number of aisles that typically need to be provided in a data centre, this is a time-consuming and tedious task. It also may delay, or be delayed by, the installation of other services at the data centre. Typically, workers carrying out different tasks on the same site at the same time will cause delays for each other. Further, there is a safety concern, not alone with respect to the workers constructing the aisles on site, but also with regard to other workers on the site at the same time.

The present invention is directed towards overcoming these problems.

### Summary of the Invention

According to the invention, there is provided a hot/cold aisle system for a data centre, including:
a prefabricated self-supporting rigid frame having a top and downwardly depending sides defining an aisle,
a roof mounted at the top of the frame to close the top of the frame,
a plurality of side panels mounted along each side to close the sides of the frame, and
means for mounting the frame on a support.

In one embodiment of the invention, the frame sides include a pair of spaced-apart upright side walls interconnected at their upper ends by a plurality of spaced-apart cross beams forming the top of the frame, said cross beams being perpendicular to the side walls, each side wall comprising a bottom rail and a top rail which are mutually parallel and interconnected by a plurality of spaced-apart uprights with diagonal bracing elements mounted between each adjacent pair of uprights.

In another embodiment, each rail comprises an outwardly facing channel.

In another embodiment, at least one side panel comprises a window panel having a translucent window pane mounted on a support frame.

In another embodiment, all the side panels are window panels.

In another embodiment, each window panel comprises a rectangular outer window frame defining a stepped opening for reception of the window pane, retaining strips engagable within the stepped opening with an inner face of associated sides of the outer window frame to retain the window pane within the stepped opening, each retaining strip having a window pane retaining flange at an inner end for cooperation with an inwardly extending window pane mounting flange on the outer window frame at a periphery of the stepped opening to clamp the window pane therebetween, and cooperating tapered mating faces at an outer end of each retaining strip and on the inner face of the window frame sides for moving the pane retaining flange and pane mounting flange together and apart, and fasteners engagable between each retaining strip and the outer frame to secure the retaining strip on the outer frame.

In another embodiment, the outer window frame comprises a P-section frame member having an outer wall and an inner wall which are parallel and spaced-apart by an outer end wall extending therebetween and perpendicular to the outer wall and the inner wall, the outer wall extending inwardly from the outer end wall further than the inner wall to form the window pane mounting flange, an inner end wall projecting inwardly from the inner wall towards the outer wall and being cranked intermediate its ends to form the tapered mating face.

In another embodiment, each retaining strip is of Z-section having a central web parallel to the outer end wall, with the window pane retaining flange at an inner end of the central web, perpendicular thereto and parallel to the window pane mounting flange of the outer window frame, a sliding flange at an outer end of the central web folded inwardly over an outer face of the central web at an acute angle to form the tapered mating face.

In another embodiment, a U-shaped insert is mounted within each P-section frame member, having parallel sides interconnected by a cross-member, the sides abutting the outer end wall and the inner end wall, a fastener comprising a locking bolt engagable through associated openings in the central web and the inner end wall with a locknut on an innermost side of the insert for securing the retaining strip on the outer window frame.

In another embodiment, a L-shaped receiver strip is mounted on an inner face of each of the bottom rail and the top rail for reception of a window panel therebetween.

In another embodiment, lower and upper retaining plates are provided at the bottom rail and at the top rail respectively to secure the window panels between the bottom rail and the top rail, the lower retaining plate having a downwardly extending flap for sealing engagement with a server cabinet in the data centre in use.

In another embodiment, the means for mounting the frame on a support comprises a plurality of spaced-apart hangers at the top of the frame for suspending the frame from an overhead support.

In another embodiment, the means for mounting the frame on a support comprises a plurality of spaced-apart feet extending downwardly from a bottom of the frame to support the frame at a desired height above a floor on which the aisle system stands in use.

In another embodiment, a number of the side wall uprights extend downwardly of the bottom rail to form the feet.

### Brief Description of the Drawings

The invention will be more clearly understood by the following description of some embodiments thereof, given by way of example only, with reference to the accompanying drawings, in which:

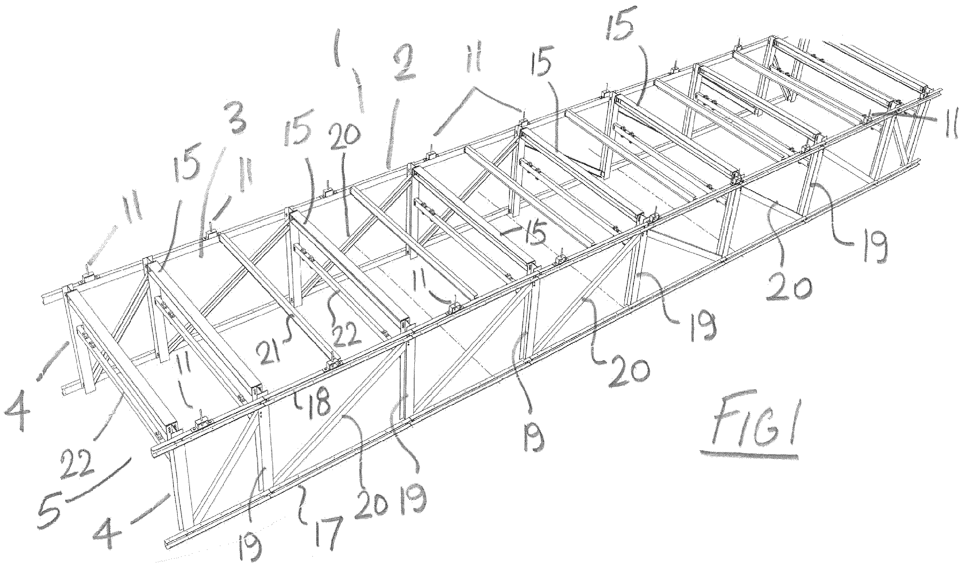

Fig. 1 is a perspective view of a frame of a hot/cold aisle system according to the invention;

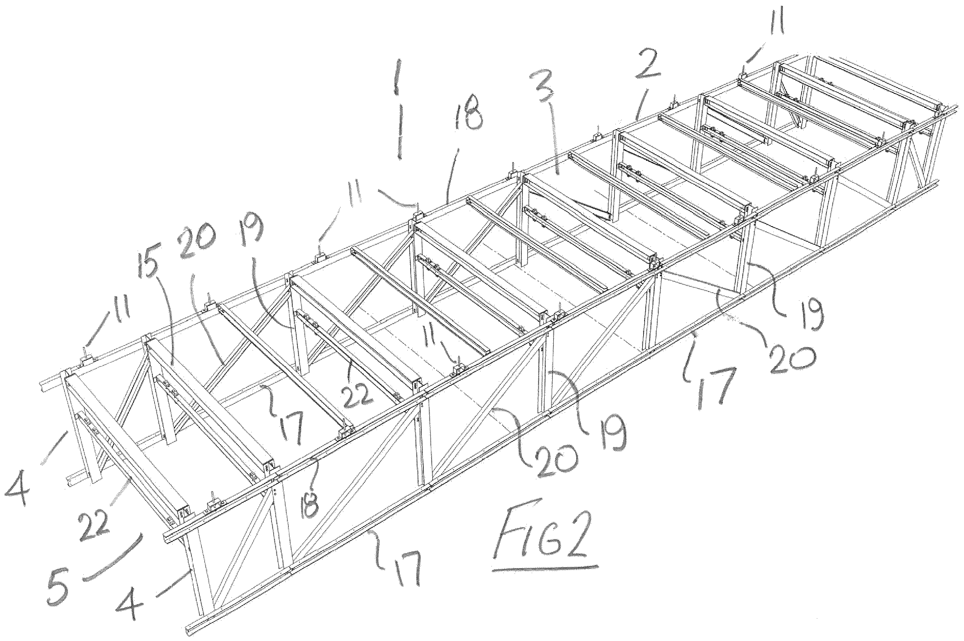

Fig. 2 is another perspective view of the frame;
Fig. 3 is a perspective view of the frame, shown in use mounted within a building;

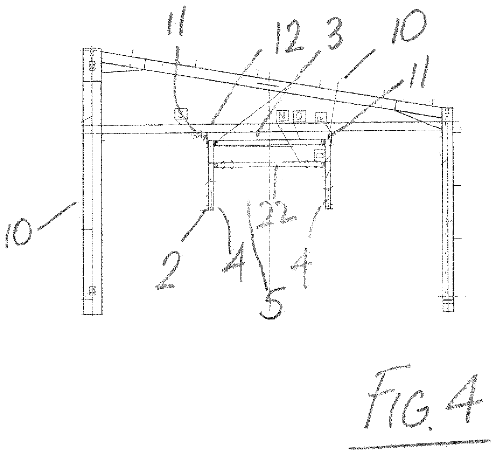

Fig. 4 is an end elevational view showing the frame mounted within the building;
Fig. 5 is a detail perspective view showing a number of window panels mounted on a side of the frame;
Fig. 6 is a front perspective view of a window panel forming portion of the system;
Fig. 7 is a rear perspective view of the window panel shown in Fig. 6;
Fig. 8 is an elevational view of the window panel shown in Fig. 6;
Fig. 9 is a side elevational view of the window panel;
Fig. 10 is a plan view of the window panel;
Fig. 11 is a side sectional elevational view of the window panel;
Fig. 12 is an enlarged detail side sectional elevational view showing portion of the window panel;
Fig. 13 is a partially exploded perspective view showing portion of a side wall of the frame;
Fig. 14 is an enlarged detail perspective view showing portion of the side wall of the frame;
Fig. 15 is an another perspective view of the side wall portion shown in Fig. 13;
Fig. 16 is an enlarged detail perspective view showing portion of the side wall;
Fig. 17 is a partially exploded perspective view showing the mounting of window panels on portion of the side wall portion;
Fig. 18 is a perspective view showing the side wall portion of the frame with window panels mounted thereon;
Fig. 19 is an enlarged detail perspective view showing portion of the side wall and a window panel;
Fig. 20 is a partially exploded perspective view of the side wall portion with window panels mounted thereon;
Fig. 21 is an enlarged detail perspective view showing portion of the side wall and a window panel;
Fig. 22 is a perspective view of the side wall portion with window panels mounted thereon;
Fig. 23 is an enlarged detail perspective view showing portion of the side wall an window panel;
Fig. 24 is a side sectional elevational view of the side wall portion and window panel;
Fig. 25 is a perspective view of the frame of the hot/cold aisle system with an alternative support means;
Fig. 26 is an elevational view of the frame arrangement of Fig. 25;
Fig. 27 is an end elevational view of the frame arrangement shown in Fig. 25; and
Fig. 28 is a perspective view of transport vehicles for the system.

### Detailed Description of the Preferred Embodiments

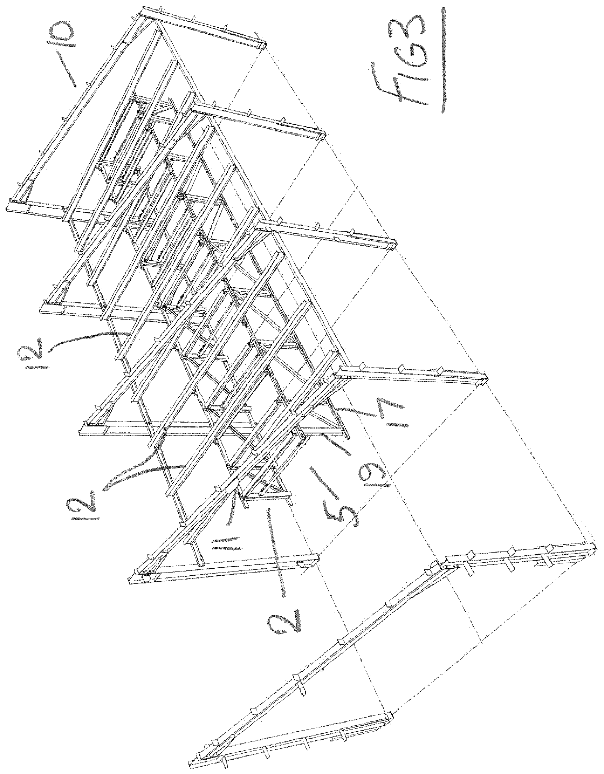

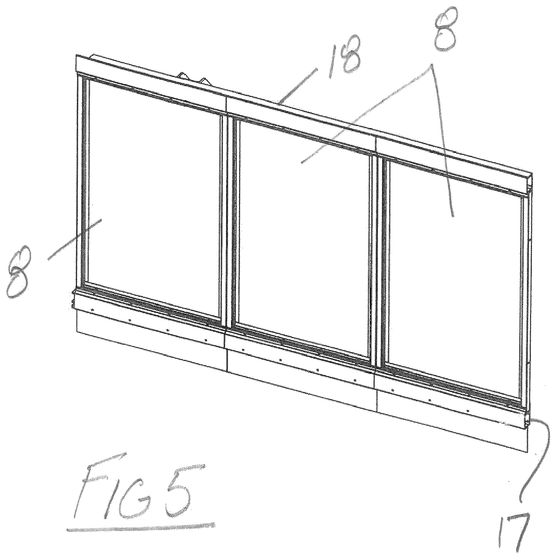

Referring to the drawings, there is illustrated a hot/cold aisle system according to the invention, indicated generally by the reference numeral 1, for a data centre. The system 1 has a prefabricated self-supporting rigid frame 2 having a top 3 and downwardly depending sides 4 defining an aisle 5 therebetween. A roof (not shown), comprising sheeting or roofing panels, is mounted on the top 3 of the frame 2 to close the top 3 of the frame 2. A plurality of side panels comprising window panels 8 (Fig. 5) are mounted along each side 4 to close the sides 4 of the frame 2. Means for mounting the frame 2 on a support such as a building structure 10 (Fig. 3) comprises a plurality of hangers 11 at the top 3 of the frame 2. In the arrangement shown in Fig. 3 these hangers 11 suspend the frame 2 from overhead rafters 12 in the building structure 10.

The frame sides 4 include a pair of spaced-apart upright side walls 4 interconnected at their upper ends by a plurality of spaced-apart crossbeams 15 forming the top 3 of the frame 2. These crossbeams 15 are perpendicular to the side walls 4. Each side wall 4 comprises a bottom rail 17 and a top rail 18 which are parallel and interconnected by a plurality of spaced-apart uprights 19 with diagonal bracing elements 20. Each bracing element 20 extends between a bottom of one upright 19 and a top of an adjacent upright 19. Each crossbeam 15 extends between upper ends of associated uprights 19 in opposite side walls 4. Intermediate crossbeams 21 may also be provided between adjacent crossbeams 15 and parallel thereto, extending between the top rails 18.

Mounted below each crossbeam 15 and extending between the uprights 19 parallel to the crossbeam 15 is a support rail 22 for mounting busbars on the frame 2 extending between opposite ends of the frame 2 adjacent each side wall 4.

The bottom rail 17 and top rail 18 of each side wall 4 comprise an outwardly facing channel. A plurality of side panels, comprising in this case window panels 8 are mounted along each side wall 4 to close the sides of the frame 2.

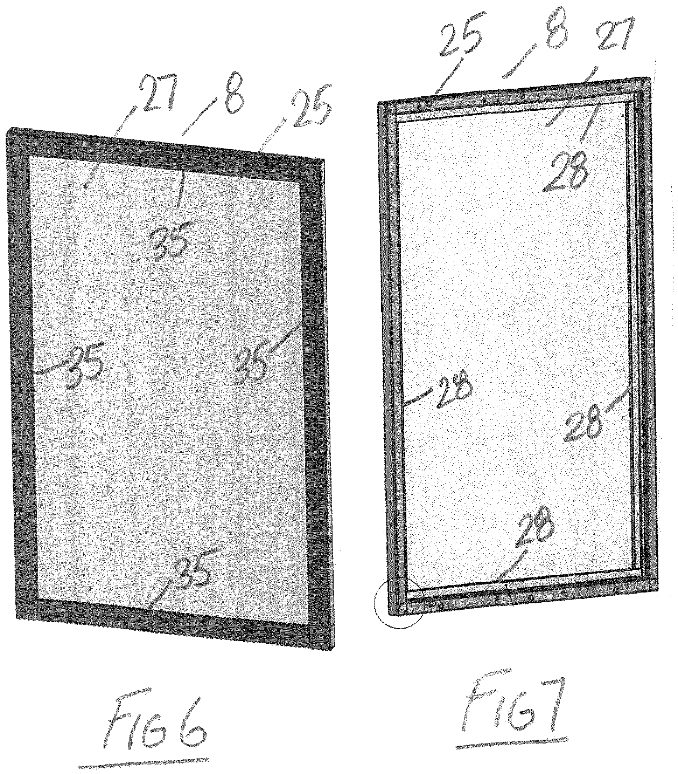

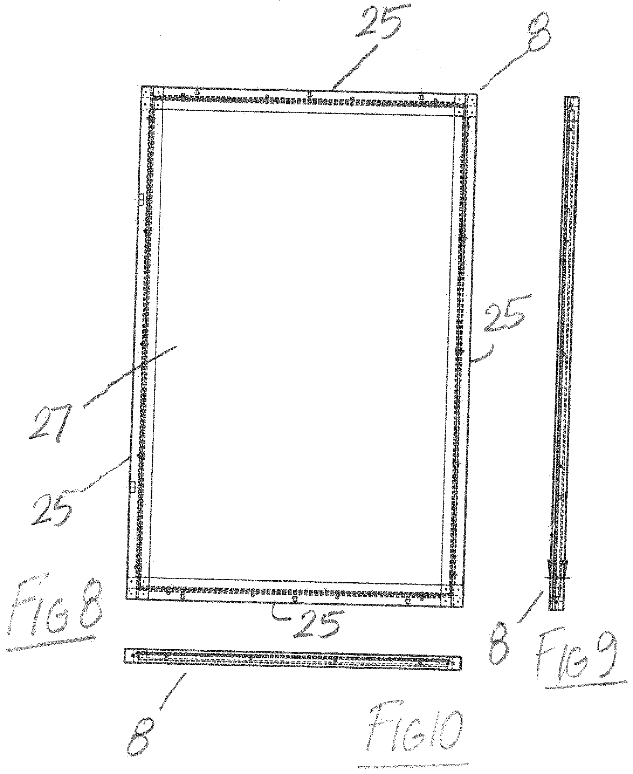

The window panels 8 are shown in more detail in Figs. 7 to 12. Each window panel 8 comprises a rectangular outer window frame 25 defining a stepped opening 26 for reception of a window pane 27. Retaining strips 28 are engagable within the stepped opening 26 to retain the window pane 27 within the stepped opening 26.

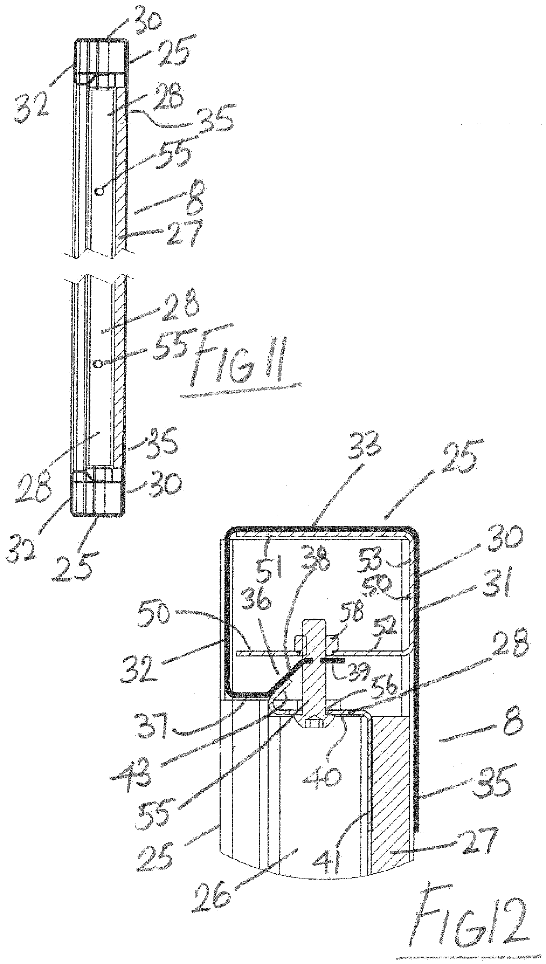

Referring in particular to Fig. 12, each side of the outer window frame 25 comprises a P-section frame member 30 having an outer wall 31 and an inner wall 32 which are parallel and spaced-apart by an outer end wall 33 extending between the outer wall 31 and the inner wall 32 and perpendicular to each of the outer wall 31 and the inner wall 32. It will be noted that the outer wall 31 extends inwardly from the outer end wall 33 further than the inner wall 32 to form a window pane mounting flange 35.

An inner end wall 36 projects inwardly from the inner wall 32 towards the outer wall 31. The inner end wall 36 is cranked intermediate its ends having an outer portion 37, a central portion 38 and an inner portion 39. The outer portion 37 and the inner portion 39 are substantially parallel and offset by the central portion 38 which is angled relative to the outer portion 37 and the inner portion 39 to form a first tapered mating face for cooperation with an associated retaining strip 28.

Each retaining strip 28 is of Z-section, having a central web 40 which lies parallel to the outer end wall 33. A window pane retaining flange 41 at an inner end of the central web 40 cooperates with the window pane mounting flange 35 to clamp the window pane 27 within the stepped opening 26. The window pane retaining flange 41 is substantially parallel to the window pane mounting flange 35, and substantially perpendicular to the central web 40.

A sliding flange 43 at an outer end of the central web 40 is folded inwardly over an outer face of the central web 40 at an acute angle to form a second tapered mating face for cooperation and sliding engagement with the central portion 38 of the inner end wall 36 of the frame member 30 to facilitate moving the window pane retaining flange 41 towards and away from the window pane mounting flange 35.

A U-shaped insert 50 is mounted within each P-section frame member 30 having parallel sides 51, 52 interconnected by a cross-member 53. The sides 51, 52 abut the outer end wall 33 and the inner portion 39 of the inner end wall 36. A fastener, which in this case comprises a locking bolt 55, is engagable through an opening 56 in the central web 40 of the retaining strip 28 and through an associated opening in the inner end wall 36 of the outer frame member 30 to engage a locknut 58 on the innermost side 52 of the insert 50 for securing the retaining strip 28 on the outer window frame 30. Typically two locking bolts 55 per retaining strip 28 are provided.

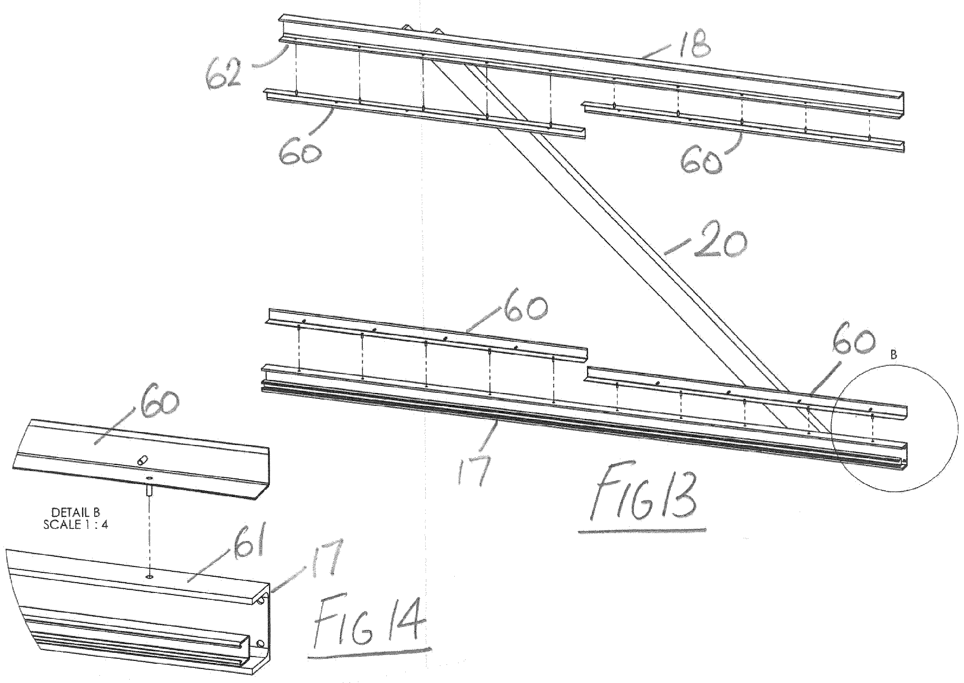

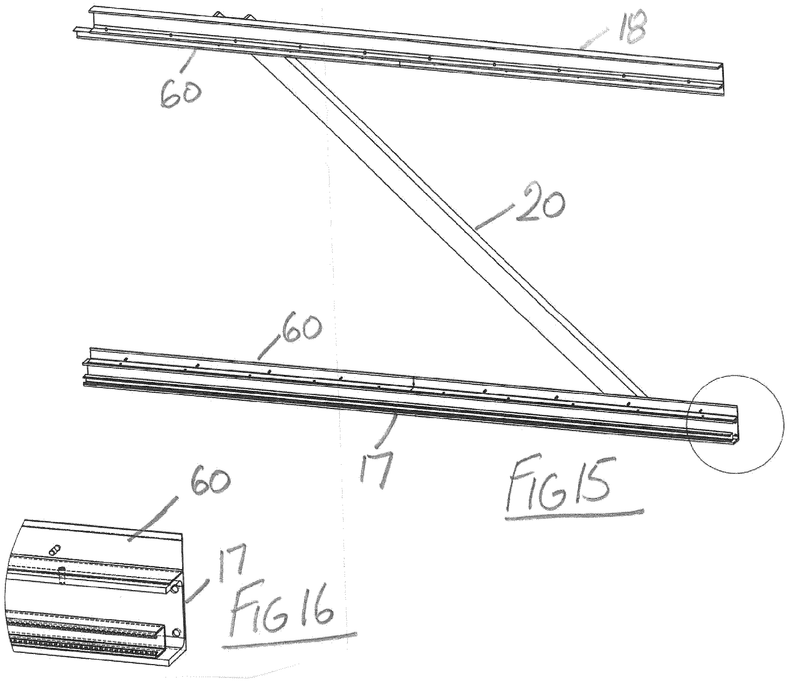

Figs. 13 to 16 show the mounting of L-shaped window panel receiver strips 60 on an inner face 61 of the bottom rail 17 and on an inner face 62 of the top rail 18.

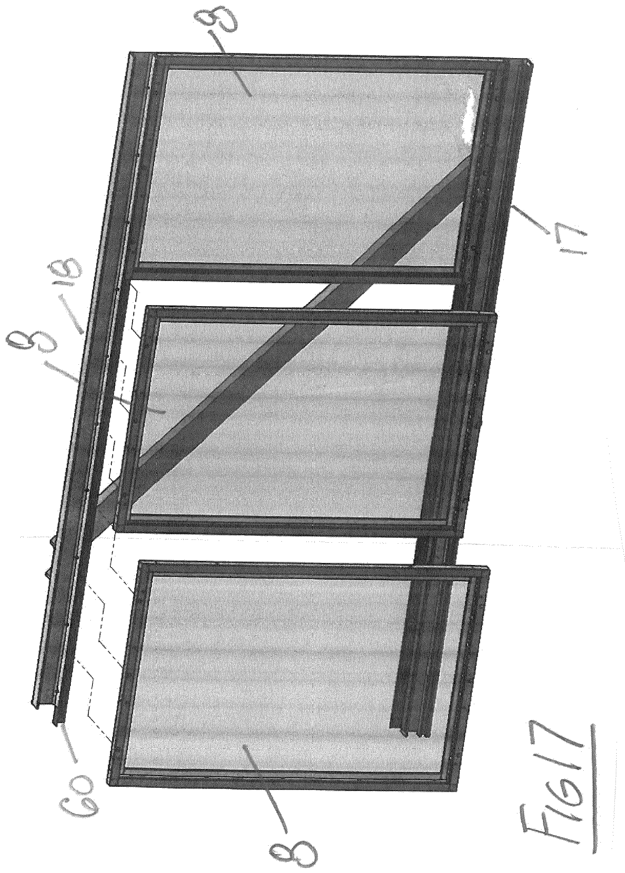

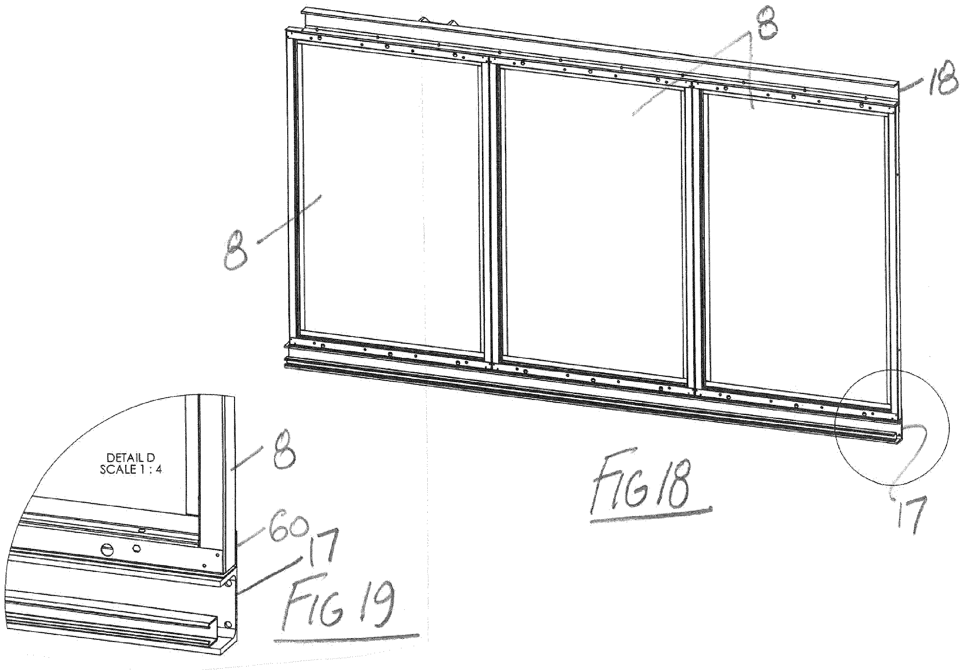

Figs. 17 to 19 show a number of window panels 8 mounted between the bottom rail 17 and the top rail 18 in engagement with the receiver strips 60.

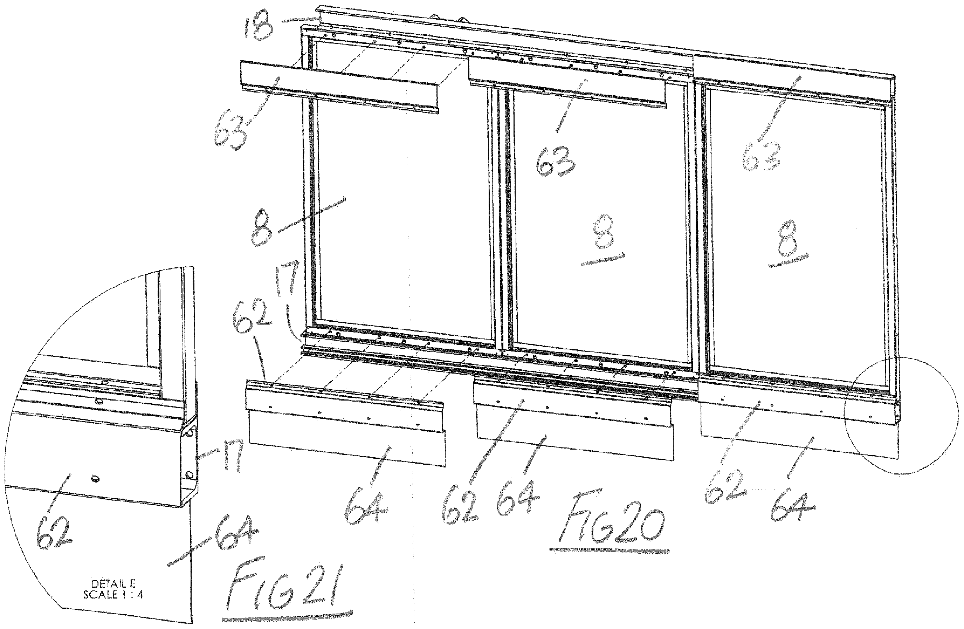

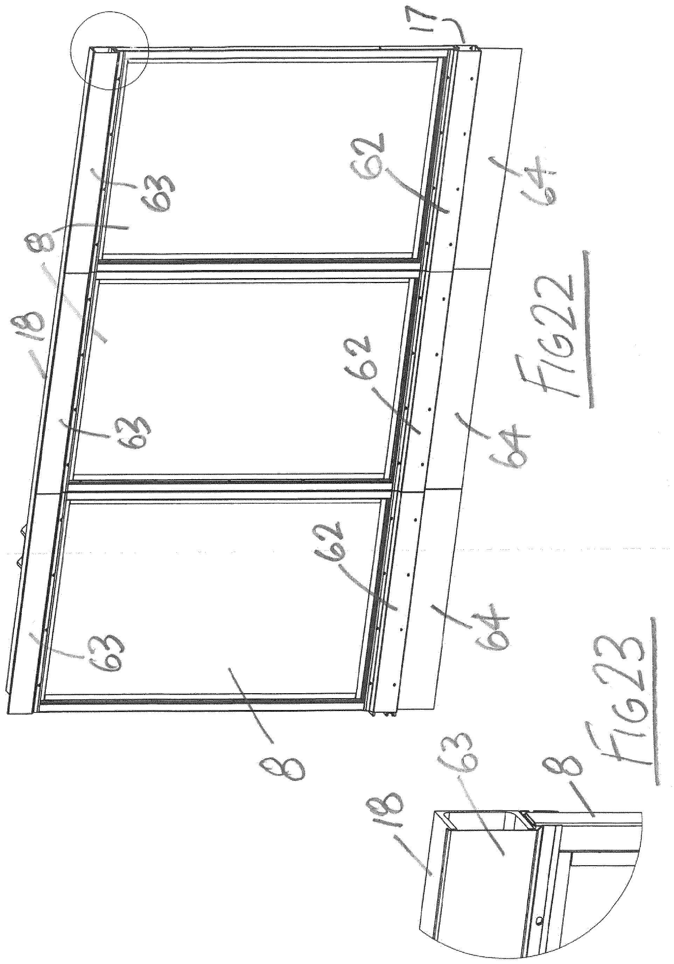

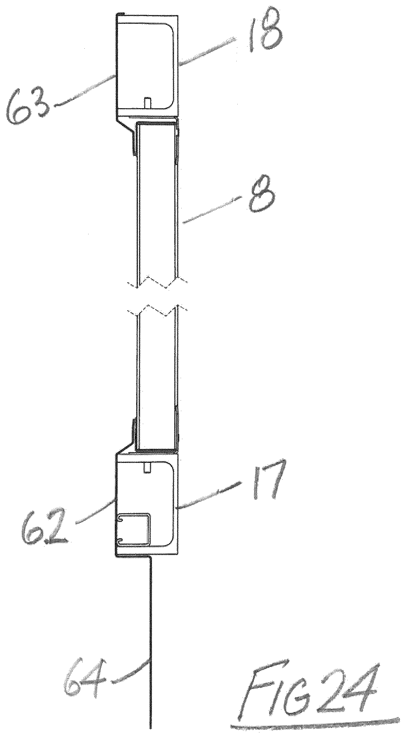

Figs. 20-24 show lower retaining plates 62 and upper retaining plates 63 which secure each window panel 8 between the bottom rail 17 and the top rail 18. It will be noted that each lower retaining plate 62 has a downwardly extending flap 64 for sealing engagement with a server switch cabinet in the data centre.

The frame 2 is of steel, and preferably the crossbeams 15 and uprights 19 are formed of steel I-beams. The bottom rail 17, the top rail 18 and the diagonal bracing elements 20 are preferably formed of channel section steel material. It will be noted that the construction is such as to form a rigid frame 2 which can be transported when assembled, thus facilitating off-site construction of the aisle system 1.

The window panes 27 comprise a translucent polycarbonate sheet with a UV protective layer.

In use, the hot/cold aisle system 1 of the invention can be pre-fabricated in a factory and then transported to the site of the data centre where it is readily, easily and quickly installed. The frame 2 can be suspended from overhead beams in the data centre by means of the hangers 11 as previously described. Alternatively, the frame 2 could be mounted on a number of ground-engaging support pillars. Providing the aisle system 1 as a self-supporting rigid frame facilitates the preparation and transport of the aisle system 1. It will be appreciated that the invention facilitates accurate construction of the aisle system 1 in a controlled and safe environment and construction can proceed in parallel with construction of the data centre, thus advoiding the delays associated with construction of an aisle system on-site and the associated delays to installation of other services at the data centre and safety concerns associated with on-site construction of an aisle system, both with regard to the workers constructing the aisle system and other workers working on other services at the site at the same time.

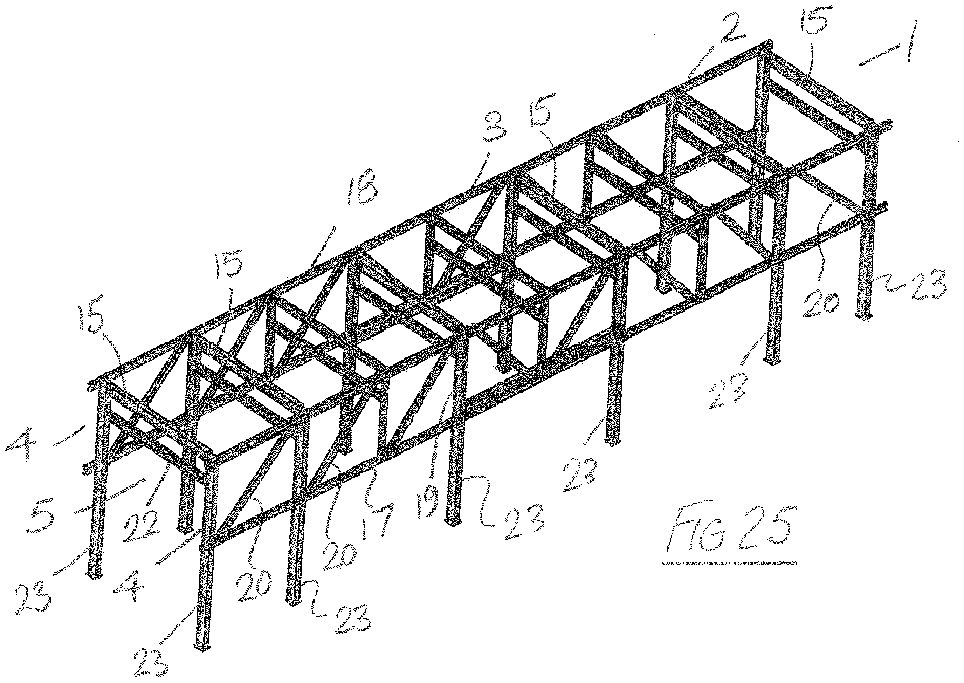

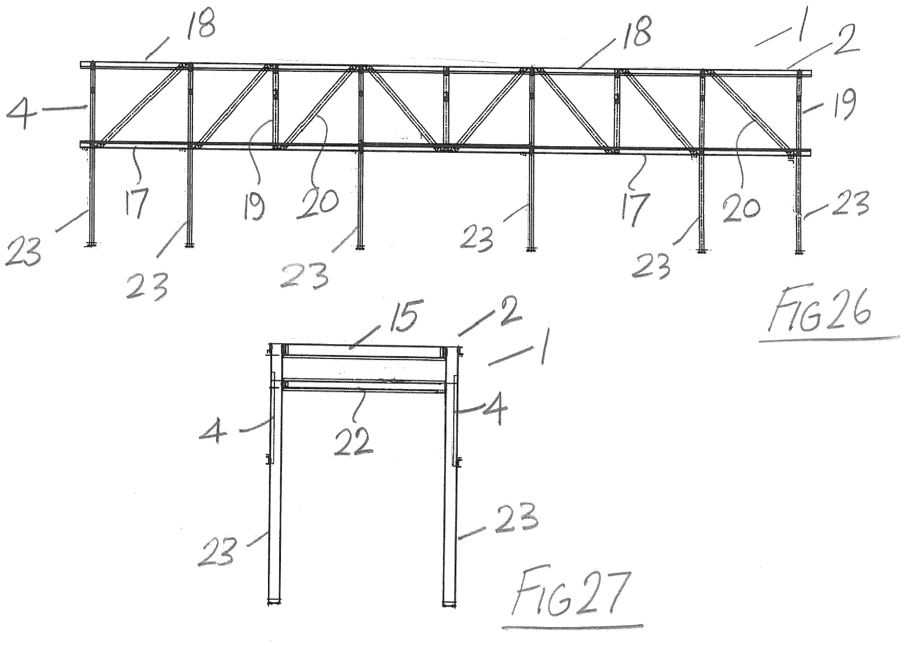

Referring now to Figs. 25 to 27, the aisle system 1 is shown with an alternative support means. Parts similar to those described previously are assigned the same reference numerals. Instead of suspending the frame 2 from a ceiling by means of hangers 11 as previously described, a number of the uprights 19 are extended downwardly of the bottom rail 17 to form support feet 23 to support the frame at a desired height above a floor on which the aisle system 1 stands in use.

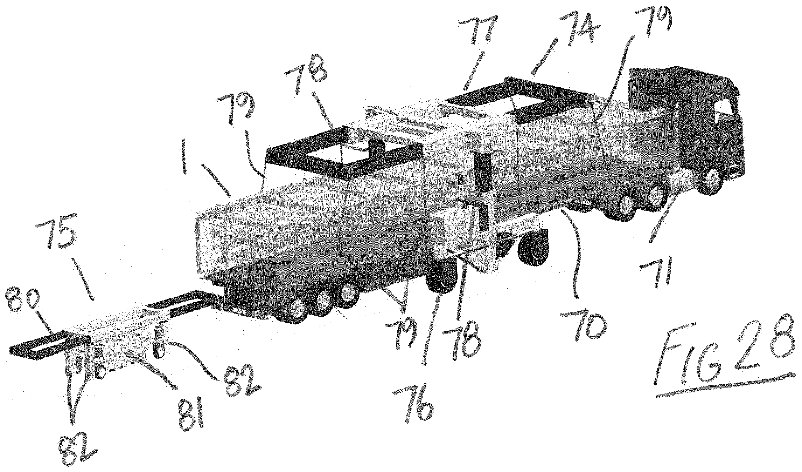

Fig. 28 shows the system 1 mounted on a semi-trailer 70 of a transport vehicle 71 to deliver the prefabricated system 1 from a factory to a site for installation. At the site, a crane 74 lifts the system 1 up off the semi-trailer 70 which is then driven out from under the system 1. A dolly vehicle 75 is then positioned below the system 1 and the crane 74 lowers the system 1 onto the dolly vehicle 75 which can be driven into position within the building in which the system 1 is to be mounted and then raised up into position for mounting on the overhead hangers 11 or the support feet 23 as previously described.

The crane 74 has a horizontal lifting frame 77 mounted between upright ram-operated telescopic support posts 78, each of which is mounted on a wheeled buggy 76. Thus, the crane 74 can position itself astride the system 1 on the semi-trailer 70 as shown in Fig. 28. Chains 79 on the lifting frame 77 are connected to the system 1. Extending the support posts 78 lifts the system 1 off the semi-trailer 70.

The dolly vehicle 75 has a lifting platform 80 mounted on a wheeled chassis 81 by ram-operated telescopic supports 82 at each corner of the chassis 81. When the system 1 is positioned on the dolly vehicle 75 by the crane 74, the dolly vehicle 75 can be manoeuvred into position and the lifting platform 80 raised by the telescopic supports 82 to a desired installation height for the system 1.

The terms "comprise" and "include", and any variations thereof required for grammatical reasons, are to be considered as interchangeable and accorded the widest possible interpretation.

The invention is not limited to the embodiments hereinbefore described which may be varied in both construction and detail within the scope of the appended claims.

## Claims

1. Hot/cold aisle system (1) for a data centre, including;
a prefabricated self-supporting rigid frame (2) having a top (30 and downwardly depending sides (4) defining an aisle (5),
a roof mounted at the top (3) of the frame (2) to close the top (3) of the frame (2),
a plurality of side panels (8) mounted along each side (4) to close the sides (4) of the frame (2), and
means (11, 23) for mounting the frame (2) on a support.

2. The system (1) as claimed in claim 1, wherein the frame sides (4) include a pair of spaced-apart upright side walls (4) interconnected at their upper ends by a plurality of spaced-apart cross beams (15) forming the top (3) of the frame (2), said cross beams (15) being perpendicular to the side walls (4), each side wall (4) comprising a bottom rail (17) and a top rail (18) which are mutually parallel and interconnected by a plurality of spaced-apart uprights (19) with diagonal bracing elements (20) mounted between each adjacent pair of uprights (19).

3. The system (1) as claimed in claim 2, wherein each rail (17, 18) comprises an outwardly facing channel.

4. The system (1) as claimed in any preceding claim, wherein at least one side panel (8) comprises a window panel (8) having a translucent window pane (27) mounted on a support frame (25).

5. The system (1) as claimed in claim 4, wherein all the side panels (8) are window panels (8).

6. The system (1) as claimed in claim 4 or claim 5, wherein each window panel (8) comprises a rectangular outer window frame (25) defining a stepped opening (26) for reception of the window pane (27), retaining strips (28) engagable within the stepped opening (26) with an inner face of associated sides of the outer window frame (25) to retain the window pane (27) within the stepped opening (26), each retaining strip (28) having a window pane retaining flange (41) at an inner end for cooperation with an inwardly extending window pane mounting flange (35) on the outer window frame (25) at a periphery of the stepped opening (26) to clamp the window pane (27) therebetween, and cooperating tapered mating faces (38, 43) at an outer end of each retaining strip (28) and on the inner face of the window frame sides for moving the pane retaining flange (41) and pane mounting flange (35) together and apart, and fasteners (55) engagable between each retaining strip (28) and the outer frame (25) to secure the retaining strip (28) on the outer frame (25).

7. The system (1) as claimed in claim 6, wherein each side of the outer window frame (25) comprises a P-section frame member (30) having an outer wall (31) and an inner wall (32) which are parallel and spaced-apart by an outer end wall (33) extending therebetween and perpendicular to the outer wall (31) and the inner wall (32), the outer wall (31) extending inwardly from the outer end wall (33) further than the inner wall (32) to form the window pane mounting flange (35), an inner end wall (36) projecting inwardly from the inner wall (32) towards the outer wall (31) and being cranked intermediate its ends to form the tapered mating face (38).

8. The system (1) as claimed in claim 6 or claim 7, wherein each retaining strip (28) is of Z-section having a central web (40) parallel to the outer end wall (33), with the window pane retaining flange (41) at an inner end of the central web (40), perpendicular thereto and parallel to the window pane mounting flange (35) of the outer window frame (25), a sliding flange (43) at an outer end of the central web (40) folded inwardly over an outer face of the central web (40) at an acute angle to form the tapered mating face (43).

9. The system (1) as claimed in claim 7 or claim 8, wherein a U-shaped insert (50) is mounted within each P-section frame member (30), having parallel sides (51, 52) interconnected by a cross-member (53), the sides (51, 52) abutting the outer end wall (33) and the inner end wall (36), a fastener comprising a locking bolt (55) engagable through associated openings in the central web (40) and the inner end wall (36) with a locknut (58) on an innermost side (52) of the insert (50) for securing the retaining strip (28) on the outer window frame (25).

10. The system (1) as claimed in any one of claims 2 to 9, wherein a L-shaped receiver strip (60) is mounted on an inner face (61, 62) of each of the bottom rail (17) and the top rail (18) for reception of a window panel (80 therebetween.

11. The system (1) as claimed in claim 10, wherein lower and upper retaining plates (62, 63) are provided at the bottom rail (17) and at the top rail (18) respectively to secure the window panels (8) between the bottom rail (17) and the top rail (18), the lower retaining plate (62) having a downwardly extending flap (64) for sealing engagement with a server cabinet in the data centre in use.

12. The system (1) as claimed in any preceding claim wherein the means for mounting the frame (2) on a support comprises a plurality of spaced-apart hangers (11) at the top of the frame (2) for suspending the frame (2) from an overhead support (12).

13. The system (1) as claimed in any of claims 1 to 11 wherein the means for mounting the frame (2) on a support comprises a plurality of spaced-apart feet (23) extending downwardly from a bottom of the frame (2) to support the frame (2) at a desired height above a floor on which the aisle system (1) stands in use.

14. The system (1) as claimed in claim 13 wherein a number of the side wall uprights (19) extend downwardly of the bottom rail (17) to form the feet (23).
